# EUROPÄISCHE PATENTANMELDUNG

(11) **EP 1 006 387 A2**
(43) Veröffentlichungstag der Anmeldung: **07.06.2000**
(21) Anmeldenummer: 99121433.9
(22) Anmeldetag: 28.10.1999
(51) Int. Cl.: G02B 13/14, G03F 7/20

(54) **Projektionsobjektiv für die Mikrolithographie**

(30) Priorität: 30.11.1998 DE 19855157
(71) Anmelder: Carl Zeiss, 89518 Heidenheim (Brenz) (DE); Carl-Zeiss-Stiftung trading as Carl Zeiss, 89518 Heidenheim (Brenz) (DE)
(72) Erfinder: Schuster, Karl-Heinz, 89551 Königsbronn (DE)

(57) **Zusammenfassung**

Ein Projektionsobjektiv, besonders für die Mikrolithographie bei 248 nm oder 193 nm, weist nach zwei Bäuchen und zwei Taillen eine ausgeprägte Linsenanordnung auf, die vorzugsweise eine weitere Taille und stets die Aperturblende (AS) enthält. Diese ist von der die zweite Taille enthaltenden negativen Linsengruppe (LG4) deutlich abgerückt und von wichtigen Korrekturmitteln umgeben. Höchste numerische Apertur (0,65 - 0,80) wird bei kleinsten Linsendurchmessern bei Beachtung der für ein derartiges Mikrolithographie-Projektionsobjektiv erforderlichen weiteren Qualitäten erreicht.

## Beschreibung

Die Erfindung betrifft ein Projektionsobjektiv mit mindestens zwei Taillen und drei Bäuchen, wie es für die Mikrolithographie entwickelt wurde und zum Beispiel aus der nicht vorveröffentlichten Patentanmeldung 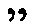 Mikrolithographisches Reduktionsobjektiv, Projektionsbelichtungs-Anlage und -Verfahren" des Anmelders vom gleichen Anmeldetag und den darin zitierten Schriften bekannt ist. Ein Beispiel daraus ist z.B. EP 0 770 895. Diese Anmeldung und die darin zitierten Schriften sollen auch Teil der Offenbarung dieser Anmeldung sein.

Im Zuge der geforderten Verkleinerung der projizierten Strukturen wird mit immer niedrigeren Wellenlängen des verwendeten Lichts gearbeitet. Bedeutend sind hier die Excimer-Laser-Quellen bei 248 nm, 193 nm und 157 nm.

Während bei 248 nm noch reine Quarzglas-Objektive gangbar sind, ist bei 193 nm wegen der anwachsenden Dispersion des Quarzglases eine Teilachromatisierung nötig, für die Kalziumfluorid als zweites Material zur Kombination mit Quarzglas zur Verfügung steht.

Kalziumfluorid-Linsen müssen jedoch aus den verschiedensten Gründen - von der Verfügbarkeit großer homogener Kristalle bis zur optischen Bearbeitungsmöglichkeit - möglichst sparsam eingesetzt werden.

Es macht wenig Sinn, die Wellenlänge abzusenken und komplett neue Systemtechnologien einzuführen, wenn nicht die numerische Apertur auf dem erreichten hohen Niveau (oberhalb 0,6, möglichst 0,65 und mehr) gehalten wird, da die Auflösung ja von dem Quotienten Lambda/NA bestimmt wird.

Auch für andere Wellenlängen, insbesondere reine Quarzglas-DUV-Systeme, ist eine Steigerung der numerischen Apertur angestrebt, ohne daß die Linsendurchmesser weiter anwachsen, da auch da Grenzen der Herstellbarkeit erreicht werden.

Es ist daher die Aufgabe der Erfindung, ein Projektionsobjektiv anzugeben, das höchste numerische Apertur bei kleinsten Linsendurchmessern ermöglicht, unter Beachtung der für ein Mikrolithographie-Projektionsobjektiv erforderlichen weiteren Qualitäten.

Dies gelingt mit den in den Ansprüchen 1-5 vorgesehenen Maßnahmen, die alle die nach der zweiten Taille vor dem Bild liegenden Linsengruppen, die Lage der Aperturblende und die Ausbildung des Blendenraums betreffen und dort eine neuartige Einschnürung vorsehen.

Anspruch 6 gibt als vorteilhaft die möglichen Kombinationen der Maßnahmen nach den vorhergehenden Ansprüchen an, was auch in den Ausführungsbeispielen aufgezeigt wird

Anspruch 7 beschreibt die besonders vorteilhafte Ausführung mit hoher numerischer Apertur von über 0,65 bzw. 0,70. Dies kann zwar als an sich immer gestellte Aufgabe gelten, es ist aber ein hervorragendes Merkmal der Erfindung, daß diese Werte sicher erreicht werden, und zwar unter auch sonst brauchbaren Bedingungen wie Bildfeld usw.

Die Eignung der erfindungsgemäßen Konstruktion als Ein-Material-Objektiv, insbesondere als Quarzglas-Objektiv wie es für das DUV bei 248nm vorgesehen wird, ist Gegenstand der Unteransprüche 8 und 9. Die Ausführung mit zwei verschiedenen Linsenmaterialien ist in Anspruch 10 beschrieben, während Anspruch 11 die Ausbildung als teilachromatisiertes Objektiv (z. B für 193 nm) mit Quarzglas und Kalziumfluorid beschreibt. Man sieht daraus die breite Anwendbarkeit des erfindungsgemäßen Objektivdesigns, das mit anderen Linsenmaterialien auch für andere Wellenlängen ausgelegt werden kann, so für 365 nm oder 157 nm.

Unteranspruch 12 zeigt die vorteilhafte Ausführung des Korrektionsmittels der Negativlinse im Blendenraum, wie es kennzeichnendes Merkmal der Ansprüche 1 und 5 ist, in der Art, daß die Negativlinsen beiderseits der Aperturblende vorgesehen sind.

In Erweiterung des Anspruchs 4 sind gemäß Anspruch 13 in diesem Bereich ebenfalls zwei sphärisch überkorrigierende Lufträume, deren Mittendicke also größer als die dicke am Rand ist, als vorteilhafte Ausführungsform vorgesehen.

Anspruch 14 gibt auch für den Bereich der ersten positiven Linsengruppe ein Konstruktionsmerkmal an. Demnach sind von den ersten drei objektseitigen Linsen zwei Negativlinsen vorzusehen, wobei bevorzugt die erste Linse negativ ist. Dies hilft zur Erreichung hoher Aperturen bei guter Petzval-Korrektur.

Der unabhängige Anspruch 15 betrifft die Einbindung der erfindungsgemäßen Projektionsobjektive in eine Projektionsbelichtungsanlage der Mikrolithographie, mit der im Rahmen konventioneller Aufbauten gesteigerte Abbildungsleistung zum Beispiel bei 248 nm oder 193 nm Laserlicht erbracht werden kann..

Anspruch 16 betrifft das vorteilhafte Verfahren zur Herstellung mikrostrukturierter Bauteile, bei dem eine derartige Projektionsbelichtungsanlage und damit ein Projektionsobjektiv nach einem der vorhergehenden Ansprüche Verwendung findet.

Näher erläutert wird die Erfindung anhand der Zeichnung.
- Figur 1: zeigt den Linsenschnitt eines ersten Ausführungsbeispiels mit NA = 0,7;
- Figur 2: zeigt den Linsenschnitt eines zweiten Ausführungsbeispiels mit NA = 0,7;
- Figur 3: zeigt den Linsenschnitt eines dritten Ausführungsbeispiels mit NA = 0,75;
- Figur 4: zeigt den Linsenschnitt eines vierten Ausführungsbeispiels mit NA = 0,8;
- Figur 5: zeigt den Linsenschnitt eines fünften Ausführungsbeispiels mit NA = 0,8, als reines Quarzlinsenobjektiv für 248 nm;
- Figur 6: zeigt den Linsenschnitt eines sechsten Ausführungsbeispiels; und
- Figur 7: zeigt typische Aberrationen zum sechsten Ausführungsbeispiel.

Ein teilachromatisiertes refraktives 193 nm Lithographieobjektiv benötigt wenigstens zwei optische Materialien. Dafür sind Quarzglas und Kalziumfluorid (CaF₂) am ehesten geeignet. Bei CaF₂ gibt es Mängel bei der Homogenität und der Doppelbrechung (neben anderen Kristallfehlern und Einschlüssen). Um den Einfluß der Doppelbrechung gering zu halten, muß die optische Weglänge im Kristall möglichst klein sein, d.h. möglichst wenig Kristall im Objektiv verwendet werden. Was den schädlichen Einfluß der Inhomogenität betrifft, gilt ähnliches, zusätzlich soll der Kristall möglichst pupillennah stehen, damit die Inhomogenitätseinflüsse nicht über die Bildhöhe variieren. Dies gelingt um so besser, je dichter der Kristall an der Systemblende steht. Die Reduzierung des Kristall-Volumens ist auch eine Notwendigkeit bezüglich der beschränkten verfügbaren Menge und nicht zuletzt eine ganz erhebliche Kostenfrage.

Beim Teilachromatisieren eines Lithographieobjektives mit CaF₂ im Blendenbereich in den Positivlinsen - alle anderen Linsen sind aus Quarzglas - ergibt sich regelmäßig ein bestimmtes Problem: Die Wirkung auf den Farblängsfehler ist durch das Ersetzen von Quarzglas durch CaF₂ in den positiven Linsen nur gering, auch wenn erfindungsgemäß die wirksamsten Einsatzmöglichkeiten angewendet werden. Dies ist eine Folge des geringen Dispersionsabstandes von Quarzglas und CaF₂. Zugleich stellt sich ein ungünstiger Farbquerfehler ein. Oftmals stehen hinter der Blende mehr positive Linsen, die man substituieren kann, als vor der Blende. Wird für die positiven CaF₂-Linsen ein Durchmesser im Blendenbereich gefordert, der kleiner ist als etwa für ein reines Quarzglasobjektiv mit guter Farbquerfehlerkorrektur, stellt sich ein ungünstiger Farbquerfehler ein. Um die Petzvalkorrektur des Objektives zu halten, wird bei einem typischen Drei-Bäuche-Aufbau der zweite Bauch größer, wenn der dritte Bauch kleiner werden soll.

Möchte man ein hochgeöffnetes Lithographieobjektiv mit z.B. bildseitig NA größer oder gleich 0,65 und gleichzeitig kleinen CaF₂-Linsendurchmessern bauen, verschärft sich die Situation dramatisch.

Um den Farbquerfehler wieder zu verkleinern, müßte man positive CaF₂-Linsen im zweiten Bauch einbringen. Dies verletzt aber die Forderung nach blendennaher Stellung, und überdies ist ja gerade der zweite Bauch jetzt im Durchmesser groß.

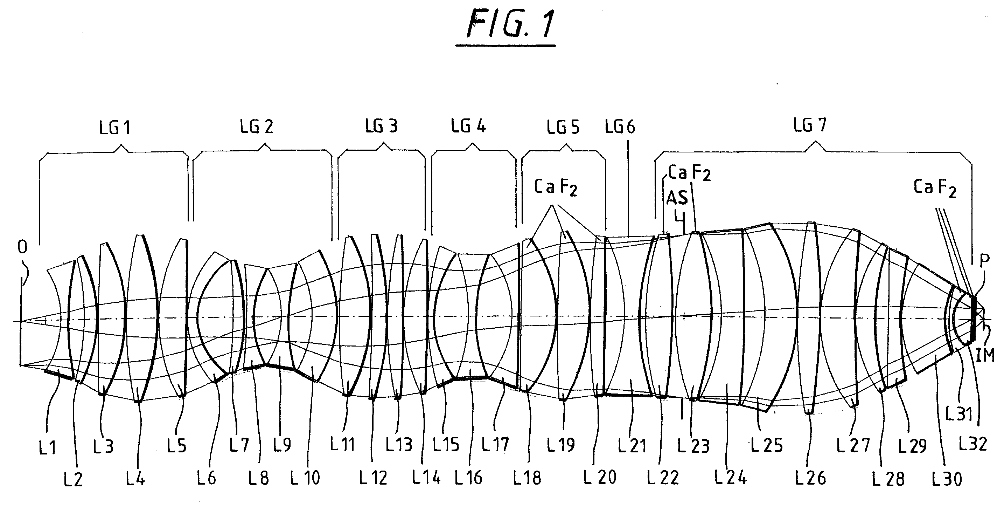

Die erfindungsgemäße Lösung des Problems besteht im Aufbau gemäß den Ansprüchen, der zunächst am Beispiel der Figur 1 und Tabelle 1 erläutert wird: Die CaF₂-Linsen L18-L20, L22, L23 werden klein gemacht im Durchmesser, der zweite Bauch LG3 wird ebenfalls klein gemacht. Dadurch bleibt der Farbquerfehler klein, aber noch nicht klein genug: Allein damit wäre die Petzvalkorrektur nun erheblich verletzt, ein stark gekrümmtes unbrauchbares Bildfeld wäre zunächst die Folge. Um weitgehend unschädlich für den Farbquerfehler die Petzvalkorrektur wieder einzustellen, wird der erste Bauch LG1, wie im Beispiel der Figur 1 ersichtlich, erheblich im Durchmesser vergrößert. Durch die Linsenfolge (L1-L8 der LG1 und LG2) -++++-+- gelingt dies. Andere Folgen wie z. B. +-+++-+- sind ebenfalls möglich, aber nicht ganz so wirkungsvoll. Mit Asphärisierung sind auch andere Folgen wie z.B.-+++-+-gangbar.

Diese Maßnahme reicht aber nicht aus, um die Petzvalkorrektur zu bewerkstelligen. Auch der "dritte Bauch" müßte größer sein. Dies ist aber nicht akzeptabel, da hier die CaF₂-Linsen L18-L20, L22, L23 stehen. Die Lösung des Problems besteht in einer Umwandlung des dritten Bauches in einen Doppelbauch LG5-LG7. Der erste Teil LG5 des Doppelbauches ist im Durchmesser klein und ist voll bestückt mit CaF₂-Linsen L18-L20. In der Verengung (Taille) LG6 sitzt eine Linse L21 mit starker negativer Brechkraft. Der zweite Teilbauch LG7 startet ebenfalls noch mit CaF₂-Linsen L23, L24, die im Durchmesser noch klein sind. Dann steigt der Durchmesser stark an. Dies wird durch stark negative Brechkraft der Linse L24 möglich, die sich an die CaF₂-Linsen L22, L23 anschließt. Ein deutlich gekrümmter sammelnder Meniskus L25, der objektivseitig konkav ist, verstärkt die Durchmesseraufweitung (Er reduziert den Farbquerfehler und verhilft zu den kleinen Durchmessern im Blendenbereich.). Vom größten Durchmesser hin zum Bild IM sammelt nun eine stark positive Gruppe L26-L28. Durch diese Gruppe mit großem Durchmesser und starker positiver Brechkraft wird schließlich erreicht, daß das System gleichzeitig bezüglich Petzvalkrümmung und Farbquerfehler hervorragend korrigiert werden kann.

Diese Anordnung verkleinert den Farblängsfehler. Die große Brechkraft der CaF₂-Linsen L18-L20 im ersten Teil LG5 des Doppelbauches ist ebenfalls der Lösung des Farbquerfehlerproblems sehr zuträglich.

Durch die Lösung der angesprochenen Probleme gelingt die Teilachromatisierung eines 193 nm Lithographieobjektivs. Fünf CaF₂-Linsen L18-L20, L23, L24, alle nahe der Systemblende AS wie das Beispiel zeigt, genügen um NA = 0,7 und ein Bildfeld von 29,1 mm bei einer Bandbreite von 0,5 pm zu erreichen. Der Reduktionsfaktor beträgt 4,0. Das Objektiv ist bildseitig telezentrisch. Alle CaF₂-Linsen sind kleiner als 220 mm im (optisch benötigten) Durchmesser und besitzen im Beispiel eine Gesamtdicke von weniger als 200 mm. Insgesamt sind 32 Linsen im Objektiv.

Die am bildseitigen Ende liegenden beiden Linsen L31, L32 und die plane Abschlußplatte P (zum Schutz des Objektivs) sind ebenfalls aus CaF₂ gefertigt. Dies hat aber nichts mit der Achromatisierung zu tun: Hier ist die Lichtintensität am höchsten, und CaF₂ ist gegen Bestrahlung stabiler als Quarzglas, insbesondere hinsichtlich der "compaction".

Die in Tabelle 1 mit angegebenen und in Figur 1 gut nachzuverfolgenden Strahlhöhen Hₘₐₓ zeigen deutlich, wie in der ersten Linsengruppe LG1 ein Bauch an Linse L4, in der zweiten (LG2) eine Taille zwischen Linse L8 und L9, in der dritten (LG3) ein Bauch an der Linse L12, in der vierten (LG4) eine Taille zu der Linse L16 ausgebildet ist.

Nicht so stark durchmoduliert wie diese, bilden die weiteren Linsengruppen LG5-LG7 einen Bauch an der Linse L19, eine erstmals vorhandene dritte Taille an der Negativlinse L21 und einen vierten Bauch an der Linse L26 aus.

Die Systemblende AS ist zwischen dieser neuen Taille (L21) und dem vierten Bauch (L26) angeordnet. Signifikant ist, daß die Systemblende AS von zwei Negativlinsen L21, L24 umgeben ist, jeweils nur durch eine positive Linse L22, L23 aus CaF₂ getrennt.

Diese Gruppierung ist gemäß den Ansprüchen 1, 5 und 12 kennzeichnend für den gefundenen Ansatz zur Objektivkorrektur. Er verlängert diese zwar, hält aber die Linsendurchmesser begrenzt dadurch, daß er sie über weite Strecken weitgehend stabil hält.

Signifikant sind auch die Lufträume zwischen den Linsen L20/L21, L21/L22 und L23/L24 mit größerer Mitten- als Rand-Dicke ausgeführt, sie wirken also sphärisch überkorrigierend Wichtig ist dabei vor allem ein solcher Luftraum vor der Aperturblende AS, wie es in Anspruch 4 Niederschlag findet. Vorteilhaft ist jedoch auch die Paarung im Sinne des Anspruchs 13, mit der die Ausführung nach Anspruch 12 weiter optimiert wird.

Eine Besonderheit der gezeigten Ausführungsbeispiele ist es auch, wie im Anspruch 3 zum Ausdruck kommt, daß die Aperturblende weit von der zweiten negativen Linsengruppe LG4 abgerückt ist. Im Beispiel Fig. 1 liegen fünf Linsen L18 bis L22 dazwischen.

Die Korrektion dieses Ausführungsbeispiels erreicht 23 mλ. Als Gasfüllung ist Helium vorgesehen.

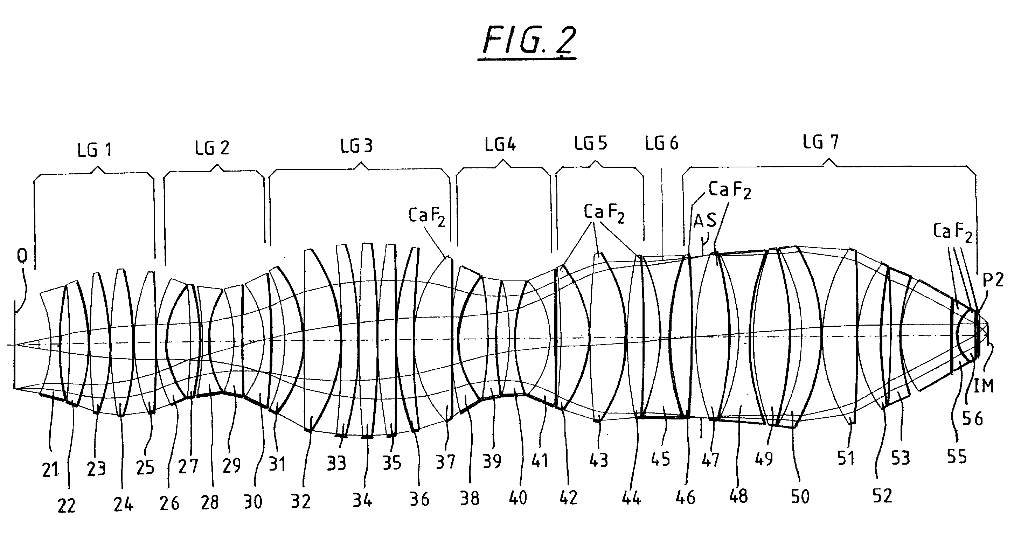

Das Ausführungsbeispiel nach Figur 2 und Tabelle 2 unterscheidet sich vom Beispiel der Figur 1 im wesentlichen dadurch, daß auch zwischen zweitem Bauch und zweiter Taille in der dritten Linsengruppe LG3 eine CaF₂-Linse L7 zur Farbkorrektur vorgesehen ist. Hier hat diese auch mäßigen Durchmesser, verbunden mit guter Wirkung. Zwischen der auf die Systemblende AS folgenden Negativlinse 48 und dem objektseitig konkaven Meniskus 50 ist hier eine Positivlinse 49 angeordnet, die von der nachfolgenden Sammelgruppe abgezogen wurde. Insgesamt ist bei gleicher Leistung hier die Linsenzahl höher als in Figur 1.

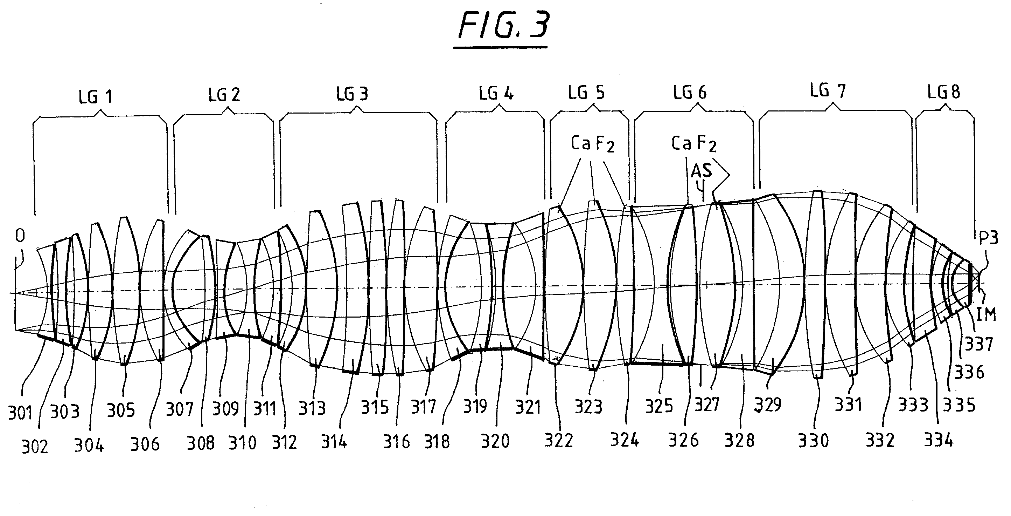

Das Ausführungsbeispiel nach Figur 3 hat die Kenndaten aus Tabelle 3.

Die gesamte Linsenzahl ist auf 37 angewachsen. Die erste Linse L1 ist zu den zwei negativen Linsen 301, 302 aufgespalten. Dies erleichtert die starke Strahlaufweitung zugunsten der Petzval-Korrektur bei Erhalt der anderen günstigen Aberrationswerte. Ein weiterer Ausbau der ersten Linsen zu einer weiteren eigenständigen Linsengruppe ist möglich. Der Meniskus L10 ist zu den Linsen 311, 312 aufgespalten. In der dritten Linsengruppe LG3 ist eine Sammellinse 317 dazu gekommen. Auch in der Taille LG4 ist die Linse L16 zu zwei Linsen 319, 320 aufgespalten. LG5 bleibt und danach folgen noch 13 statt 12 Linsen. Die damit gewonnenen Freiheitsgrade sind nützlich, um die mit der erhöhten Apertur von NA = 0,75 einhergehende drastisch erhöhte Fehlerbelastung zu kompensieren.

Die aufdie fünfte Linsengruppe LG5 mit dem dritten Bauch folgenden Linsen werden für dieses Beispiel in abweichender Gruppenaufteilung beschrieben (ohne daß sich dadurch sachlich etwas ändert).

Die Gruppe LG6 umfaßt die vierte Strahltaille an der Linse 325 und die von zwei Negativlinsen 325, 328 mit zwischengeschalteten positiven CaF₂-Linsen 326, 327 umgebene Systemblende AS. Wie bei Figur 1 wird diese Gruppe in ihrer Korrekturwirkung von bikonvexen Luftlinsen vor und nach den beiden Negativlinsen 325, 328 unterstützt. Die Linsengruppe LG7 umfaßt den objektivseitig konkaven Meniskus 329 und vier Sammellinsen 330-333. Der vierte Bauch ist an Linse 330 ausgebildet. Dieser Bereich entspricht der Fokussiergruppe der Figur 1.

Die nachfolgende hier separat bezeichnete Linsengruppe LG8 weist wieder negative Brechkräfte auf. Ihre Funktion ist in gattungsgemäßen Objektiven verbreitet. Sie sorgt dafür, daß die hohen Strahlwinkel entsprechend der numerischen Apertur erst in den letzten Linsen vor dem Bild IM auftreten, und damit zugleich ganz wesentlich dafür, daß die Linsendurchmesser beschränkt bleiben. Hier ist der dicke Meniskus L30 der Figur 1 in zwei Menisken 334, 335 aufgespalten.

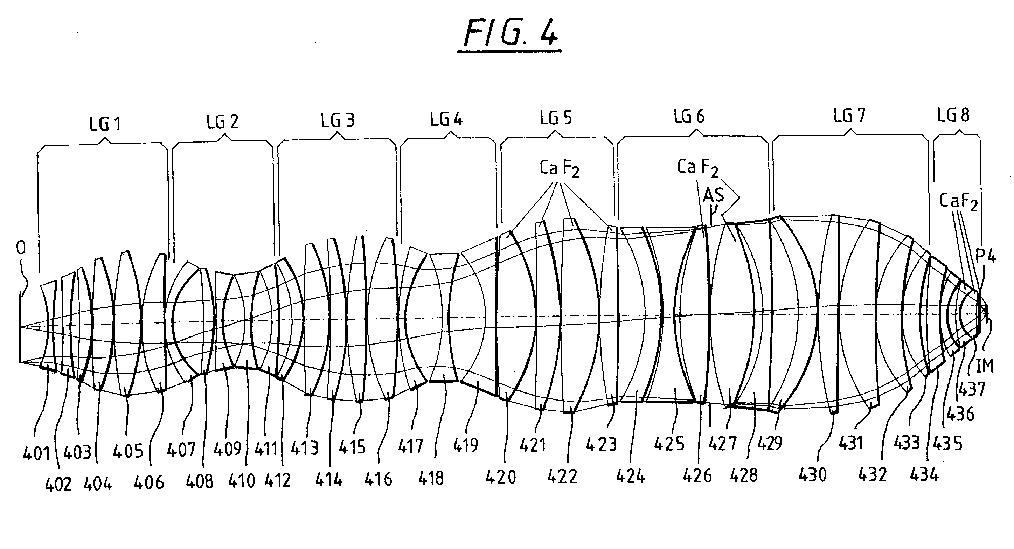

Das vierte Ausführungsbeispiel nach Figur 4 und Tabelle 4 weist eine weiter gesteigerte numerische Apertur von 0,8 auf. Die Linsenzahl beträgt hierbei ebenfalls 37. Gegenüber Figur 3 sind die Linsengruppen LG3 und LG4 wieder vereinfacht. LG5 weist jetzt aber eine zusätzliche positive Linse 423 auf. Auch LG6 ist durch Aufspaltung der Negativlinse 325 zum Meniskus 424 und zur Negativlinse 425 bei erheblicher Dickenzunahme mit zusätzlicher Korrekturfunktion versehen. In der Gruppe LG7 ist der Meniskus 429 zugunsten der Sammellinse 431 dünner geworden.

Zur Achromatisierung sind wie bei den vorherigen Beispielen Figur 1 und 3 die Positivlinsen 420-423 und 426, 427 der Linsengruppen LG5 und LG6 in Blendennähe aus CaF₂ gefertigt. Der größte Durchmesser einer CaF₂-Linse ist bei Linse 22 mit 315 mm erreicht. Größte Linse überhaupt ist Linse 30 mit 325 mm Durchmesser. Diese Werte sind natürlich fertigungstechnisch anspruchsvoll, in Anbetracht der Leistung des Objektivs aber nicht zu hoch. Auch die Linsen 436 und 437 sowie die Abschlußplatte P4 sind aus CaF₂ gefertigt, aus Gründen der Compaction, wie zu Figur 1 erklärt.

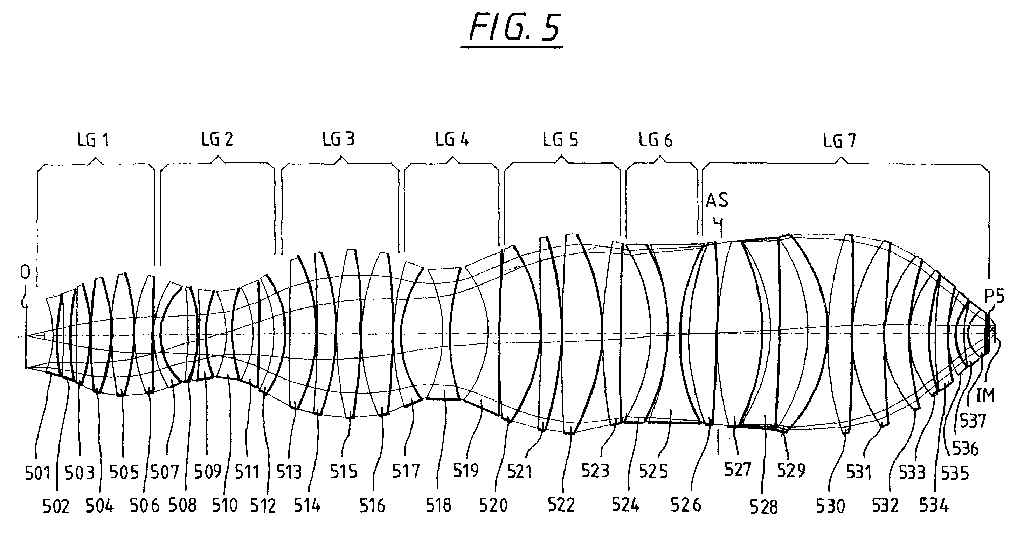

In Figur 5 und Tabelle 5 wird ein fünftes Beispiel vorgestellt, ebenfalls mit der extremen numerischen Apertur von 0,8. Hier handelt es sich um ein DUV-Objektiv für 248 nm, das als reines Quarzobjektiv ausgeführt ist.

Im Vergleich zu anderen Objektivtypen ist hier zwar die Baulänge mit Ob - IM = 1695 mm groß, es gelingt aber, die große NA = 0,8 bei einem Bildfelddurchmesser von 27,2 mm mit einem größten Linsendurchmesser von 341 mm (Linse 529) auszuführen.

Der Farblängsfehler CHV (500 pm) = 0,11 mm ist weiter verbessert, bei gutem Farbquerfehler CHV (500 pm) = -0,41 mm und einem größten RMS-Fehler = 18,7 mλ über das ganze Bildfeld.

Wie beim Beispiel der Figur 4 sind hier 37 Linsen angeordnet, in weitgehend gleichartigem Aufbau. Auch hier bewährt sich das erfindungsgemäße Konzept, ausgehend vom Aufbau mit zwei Taillen (LG2, LG4) und den zwei ersten Bäuchen (LG1, LG3) des Lichtbündels, nicht einen einfachen dritten Bauch, sondern einen durch eine dritte, wenn auch nicht stark ausgeprägte, Taille LG6 geteilten Doppelbauch LG5, LG7 vorzusehen. Die Systemblende AS ist dann in diesem nahe der Taille LG6 angeordnet, zwischen Negativlinsen 525, 528.

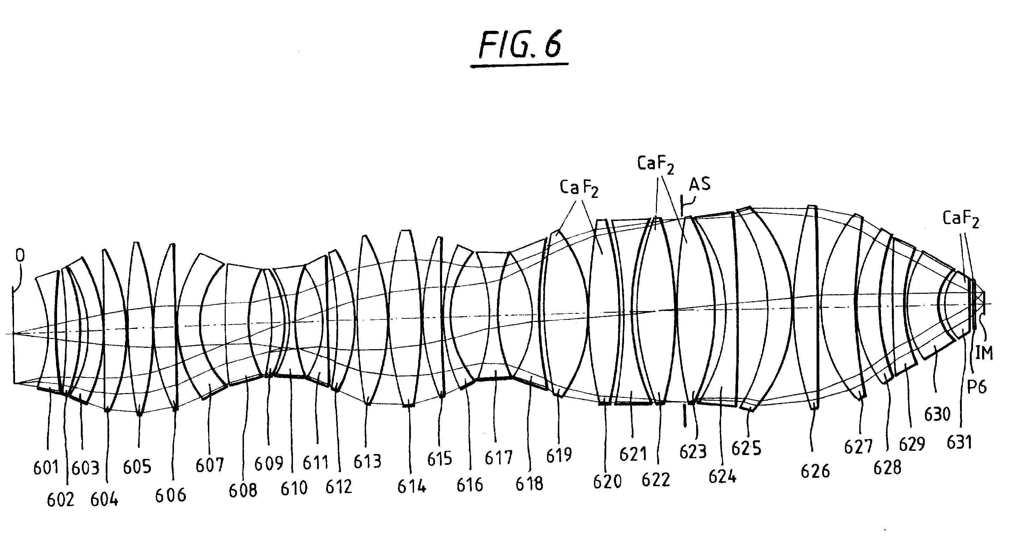

Das Ausführungsbeispiel nach Figur 6 und Tabelle 6 ist wieder für 193 nm-Excimer-Laser ausgelegt und hat die bildseitige numerische Apertur von NA = 0,7. Gegenüber den vorhergehenden Beispielen ist aber die Zahl der Linsen deutlich auf 31 reduziert. Mit vier achromatisierenden CaF₂-Linsen und einer Compaction-verhindernden CaF₂-Linse plus CaF₂-Planplatte P6 sind auch weniger CaF₂-Elemente eingesetzt. Dies ergibt insgesamt erhebliche Einsparungen bei den Herstellkosten.

Die wesentliche Besonderheit ist, daß die ersten drei Linsen 601, 602, 603 nach der Objektebene 0 negative, positive und negative (-+-) Brechkraft aufweisen, wobei die dritte Linse ein objektseitig konkaver Meniskus ist. Vergleichsweise sind bei den Beispielen nach Figur 1 und 2 -++ und nach Figur 3 bis Figur 5 --+ Anordnungen vorgesehen, wobei die zweite + Linse bei Figur 1 und 2 bikonvex ist.

Mit dieser Maßnahme gelingt es, den Durchmesser der ersten Linsengruppe (bei der Linse 605) aufdas Niveau der zweiten Linsengruppe (bei der Linse 614) anzuheben und somit schon in der ersten Linsengruppe die Petzvalsumme günstig zu beeinflussen. Gleichzeitig können Telezentrie, Verzeichnung und weitere Abbildungsfehler optimiert werden.

Ein weiterer Ausbau der ersten Linsen zu einer eigenständigen Linsengruppe ist hier ebenfalls möglich.

Beiderseits der Systemblende AS sind zwei bikonvexe positive CaF₂-Linsen 622, 623 angeordnet, eingerahmt von zwei negativen Quarzglaslinsen 621, 624. Dazwischen sind jeweils positive Luftlinsen wie auch in den vorhergehenden Beispielen als typische Korrekturmittel vorgesehen.

Davor sind nur zwei positive CaF₂-Linsen und damit insgesamt nur vier CaF₂-Linsen zur Achromatisierung eingesetzt.

Nachfolgend ist die Linse 624 als objektseitig konkaver positiver Meniskus ebenfalls typisch für die vorgestellte Objektivart ausgebildet.

Eine dritte Taille ist hier an der objektseitigen Fläche der Linse 624 nur ansatzweise vorhanden. Es wird aber der typische rund um die Systemblende AS lange Bereich stabiler Linsendurchmesser ausgebildet.

Am bildseitigen Ende ist es gelungen, das in den vorhergehenden Beispielen vorhandene Linsenpaar mit stark gekrümmtem dünnem Luftspalt zu einer dicken Linse 631 zu vereinigen. Diese, zusammen mit der vorangehenden Linse 630 und der planen Abschlußplatte P6 ist aus CaF₂ gefertigt, wie in den vorigen Beispielen zum Schutz vor störenden Compaction-Effekten.

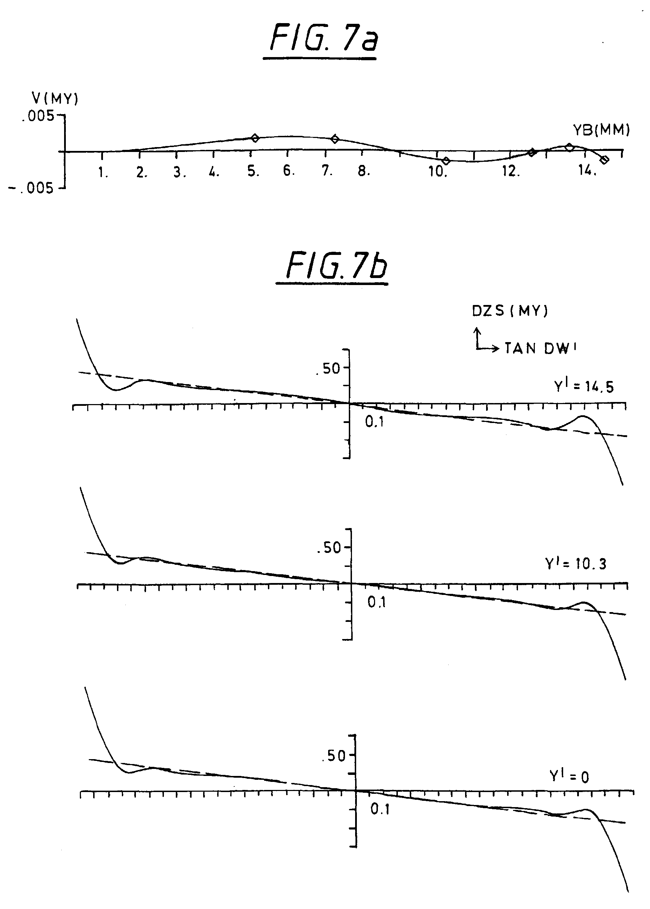

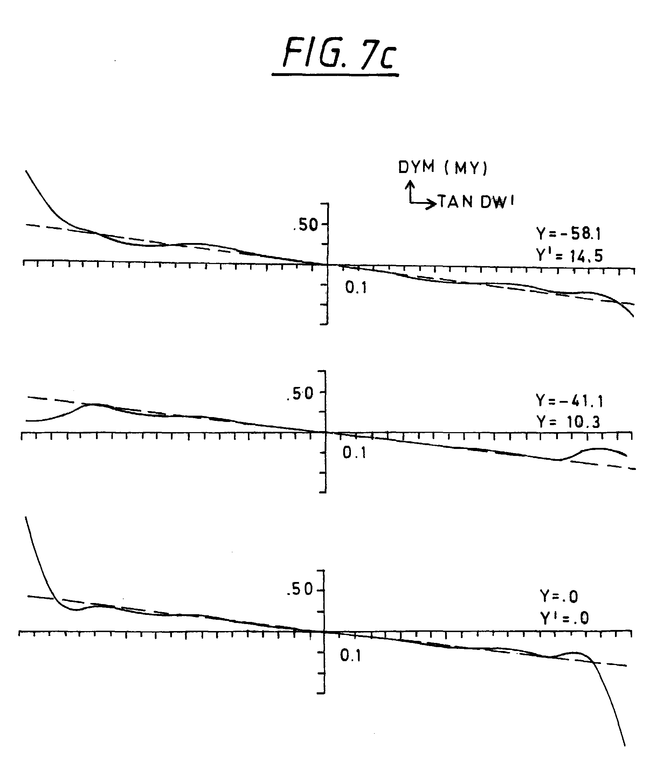

Die erreichte gute Korrektion dieses Beispiels zeigen die Aberrationskurven der Figur 7. Figur 7a gibt die Verzeichnung (in µm) als Funktion der Bildhöhe YB (in mm). Ihre größten Beträge liegen bei 2 nm.

Figur 7b gibt für die Bildhöhen Y' = 14,5 mm, 10,3 und 0 die sagittale Queraberration DZS als Funktion des halben Aperturwinkels DW' an.

Figur 7c gibt für die gleichen Bildhöhen die meridionale Queraberration DYM an. Beide zeigen bis zu den höchsten DW' hervorragenden Verlauf.

Die verschiedenen Beispiele zeigen die große Tragfähigkeit dieses Konzepts für verschiedene Ausführungsformen bei sehr hohen Aperturen.

Insgesamt gelingt es mit der erfindungsgemäßen Anordnung, klassische axialsymmetrische rein refraktive Objektive mit hoher numerischer Apertur für die Mikrolithographie mit Strukturbreiten unter 0,2 µm anzugeben, deren Qualitäten noch vor kurzem nur katadioptrischen oder katoptrischen Systemen zugebilligt wurden.

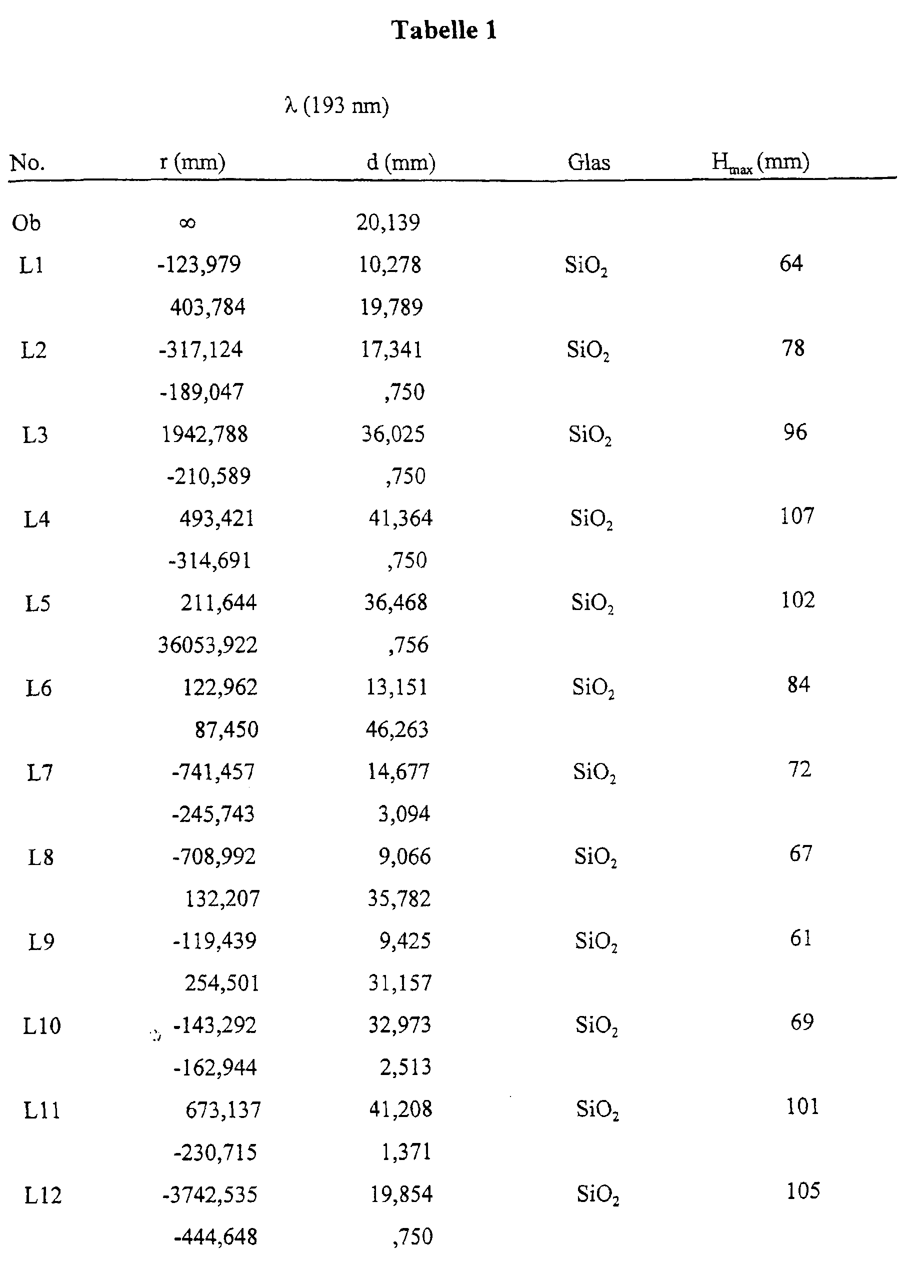

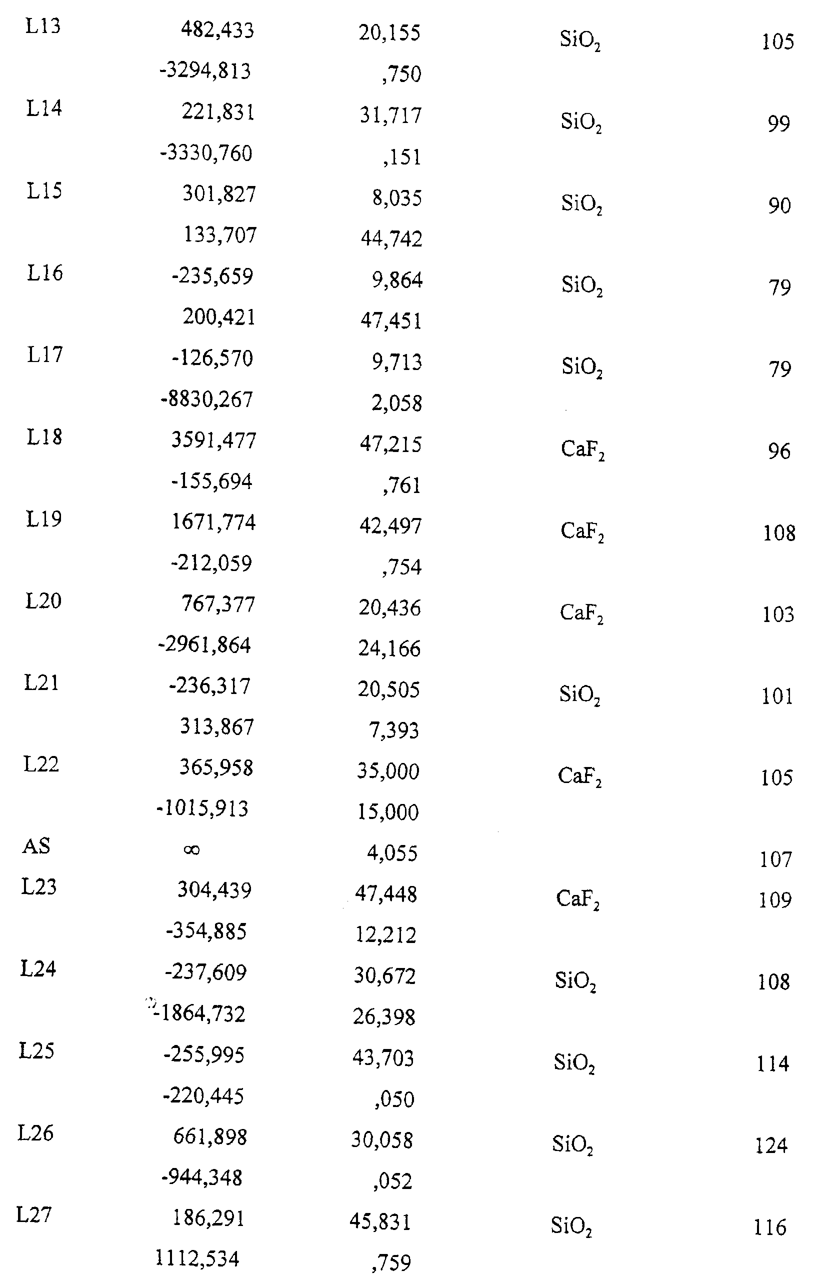

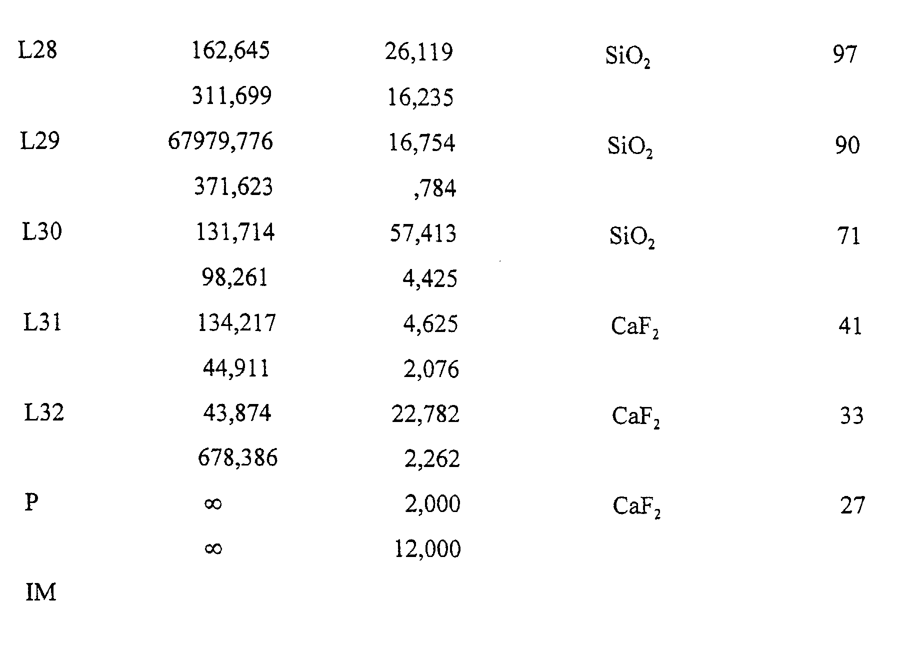

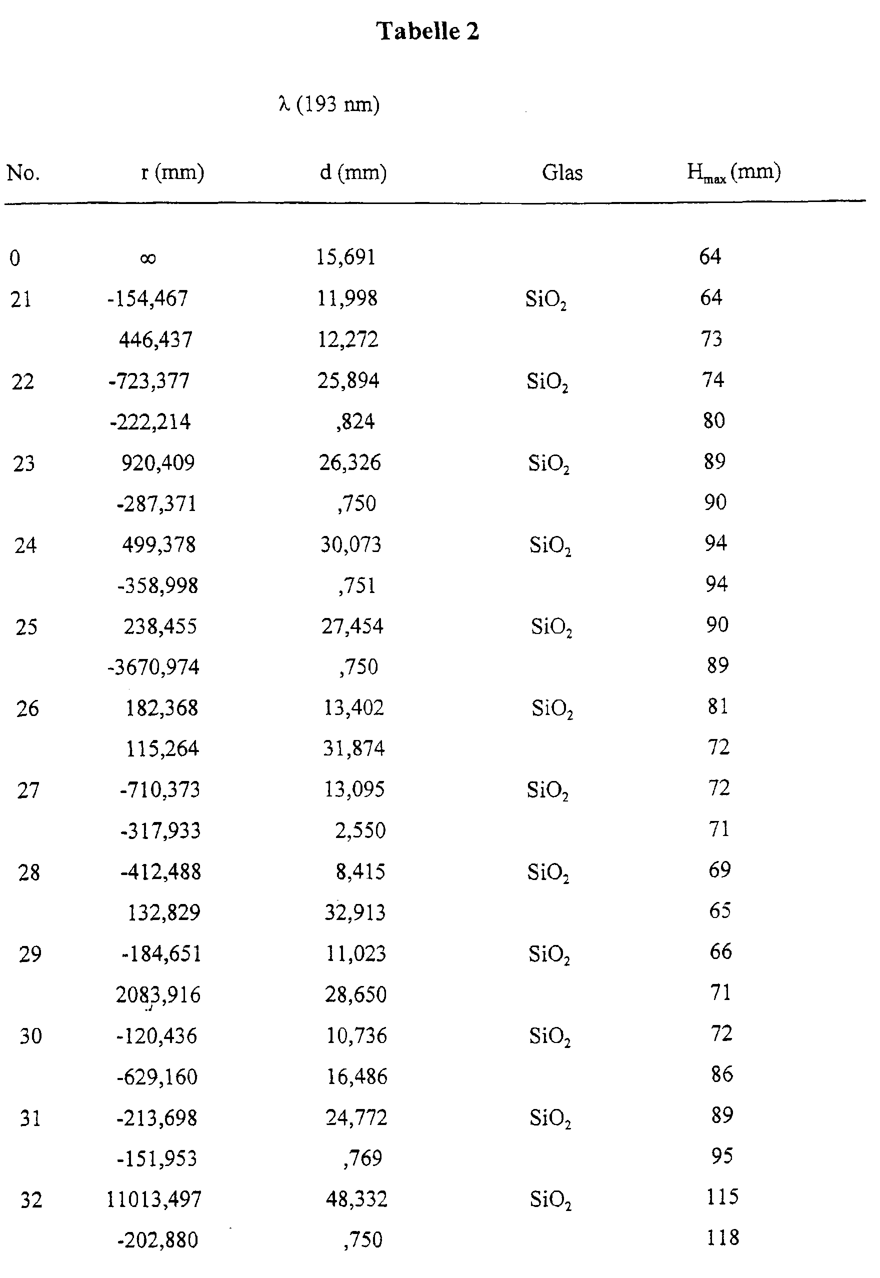

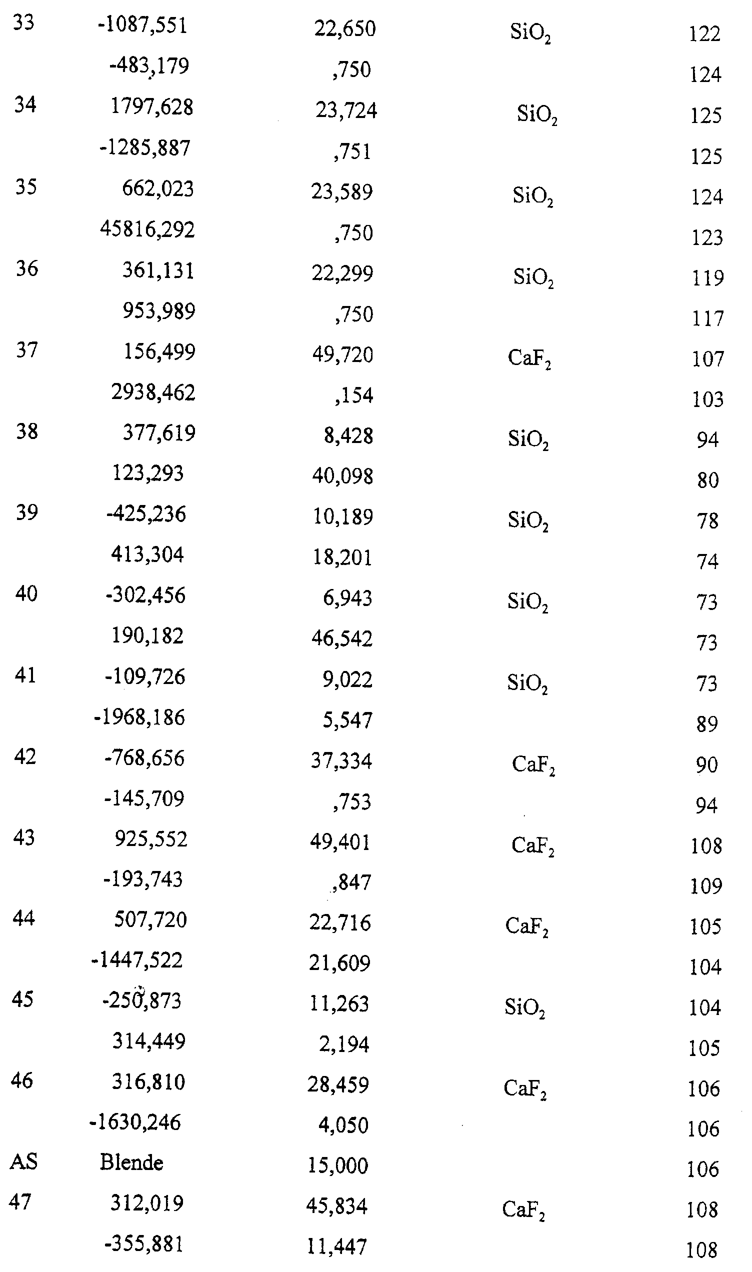

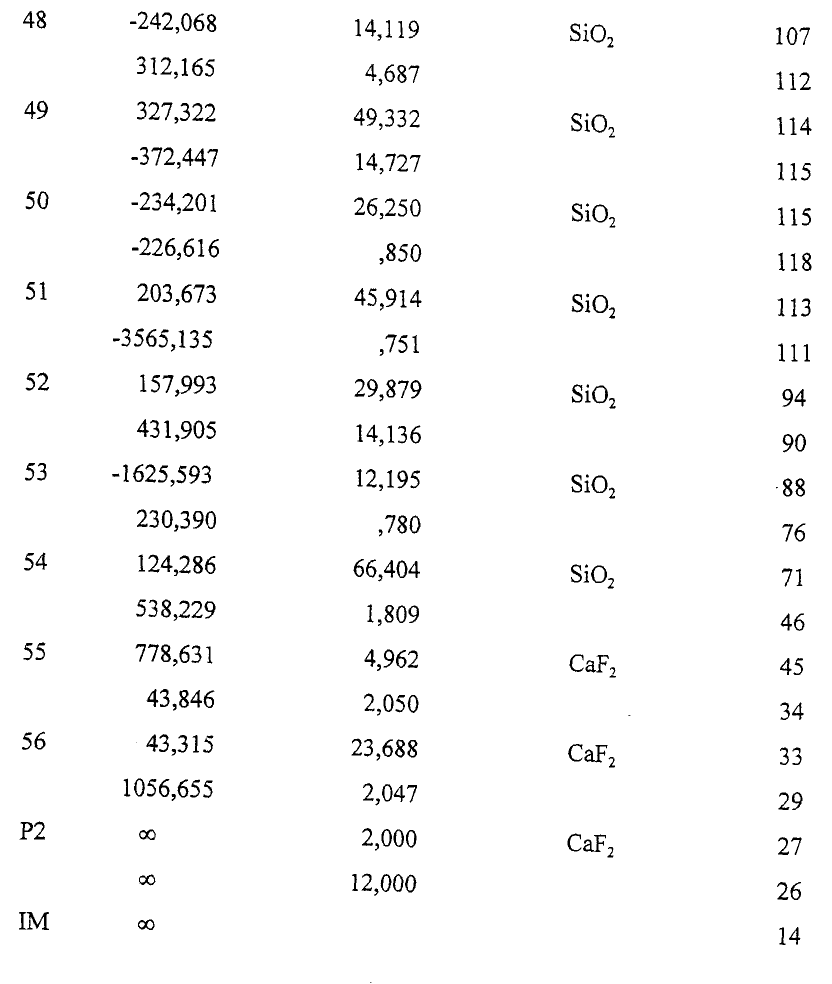

**Tabelle 3**

| | |
|---|---|
| Bildseitige numerische Apertur | 0,75 |
| Bildfelddurchmesser | 29 mm |
| Linsen | 37 |
| davon CaF₂ | 5 |
| chromatischer Längsfehler | CHL (500 pm) = 0,15 mm |
| chromatischer Querfehler | CHV (500 pm) = -0,55 mm |

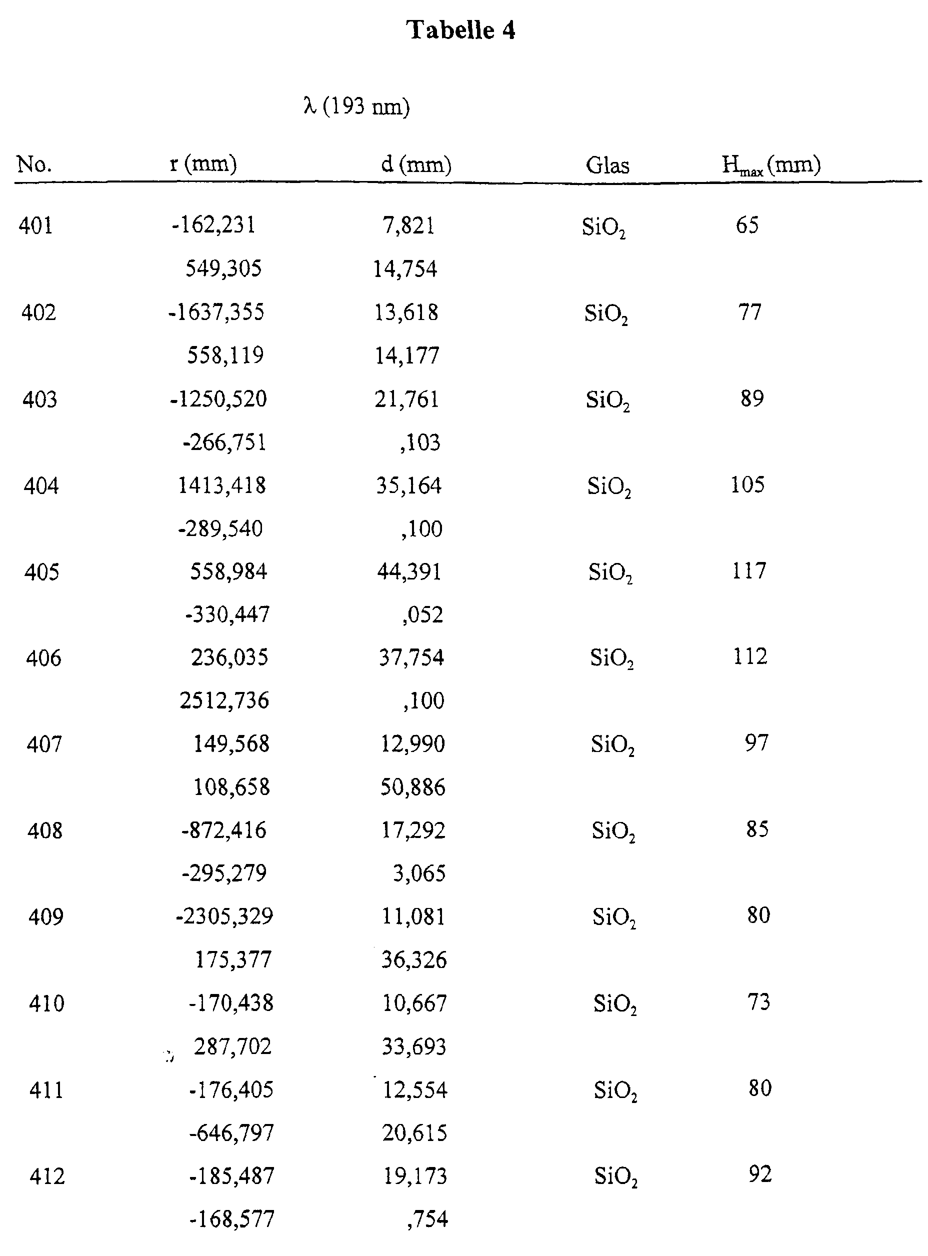

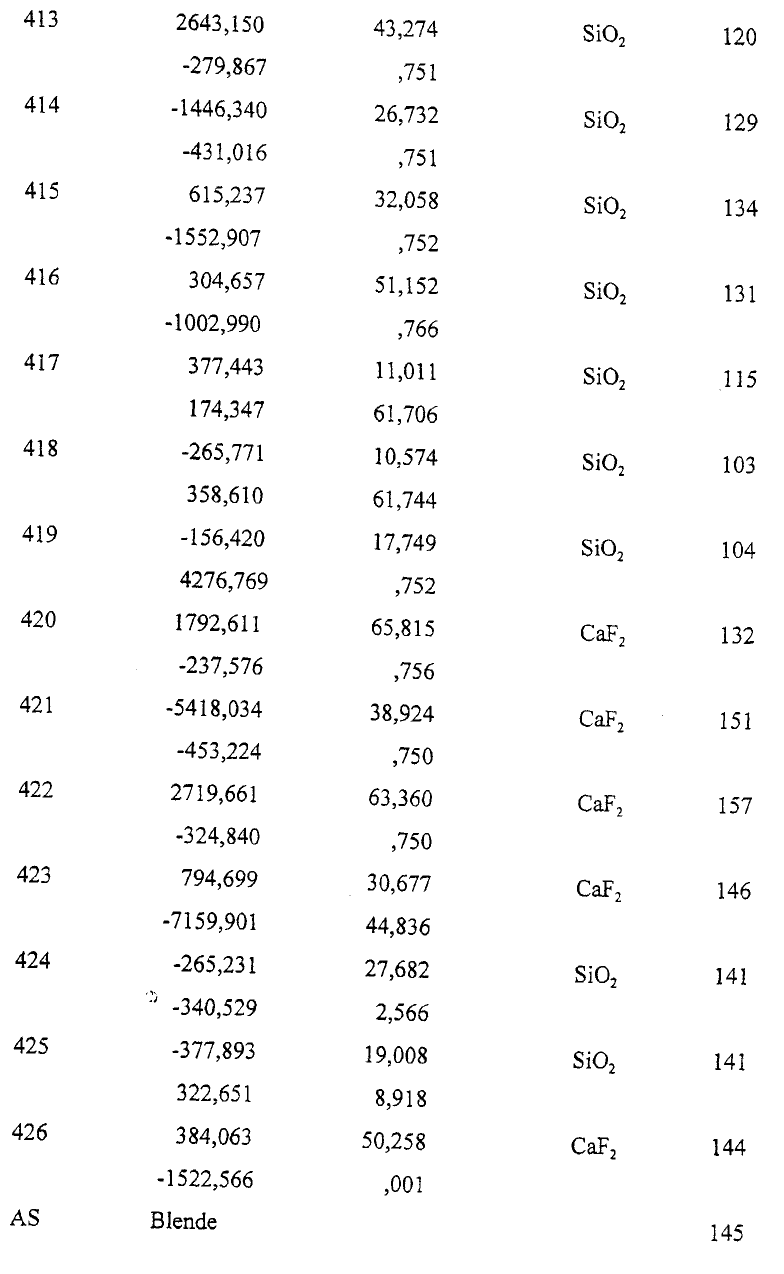

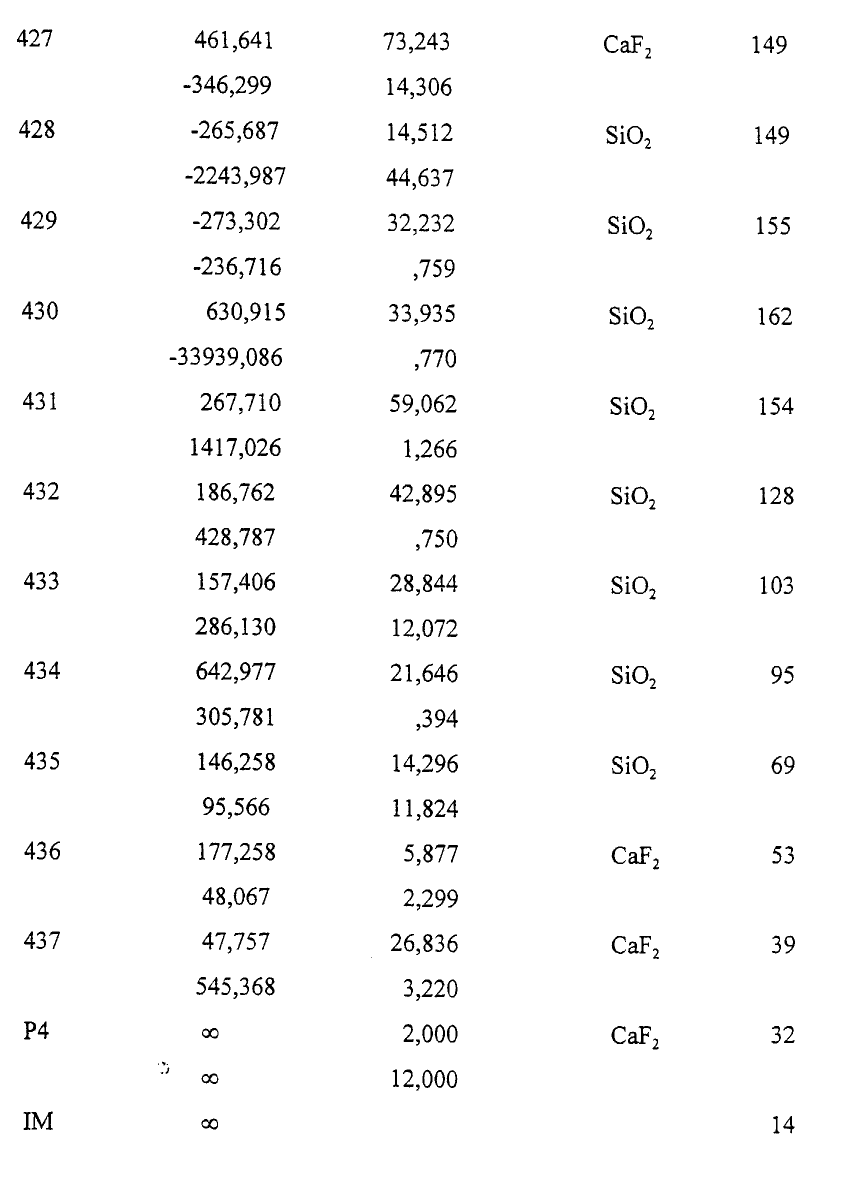

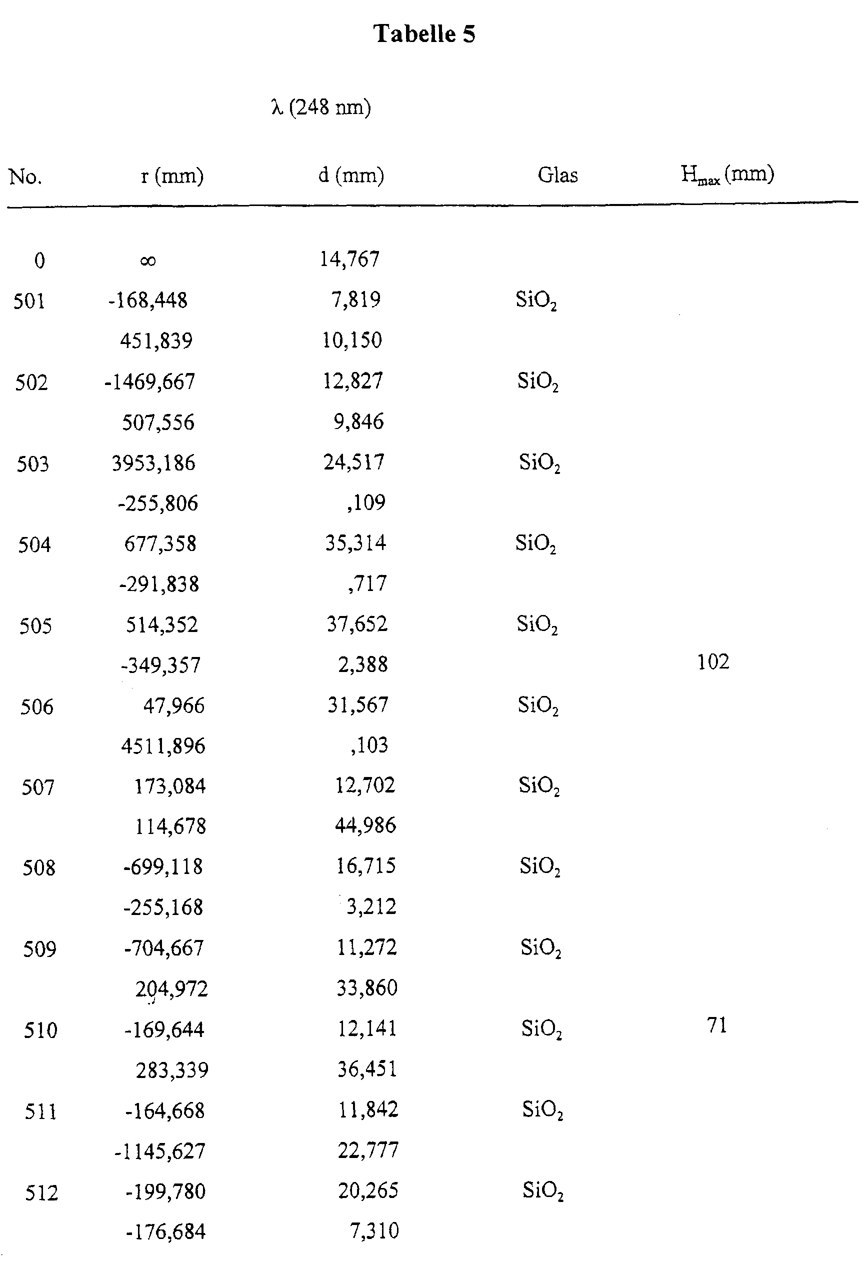

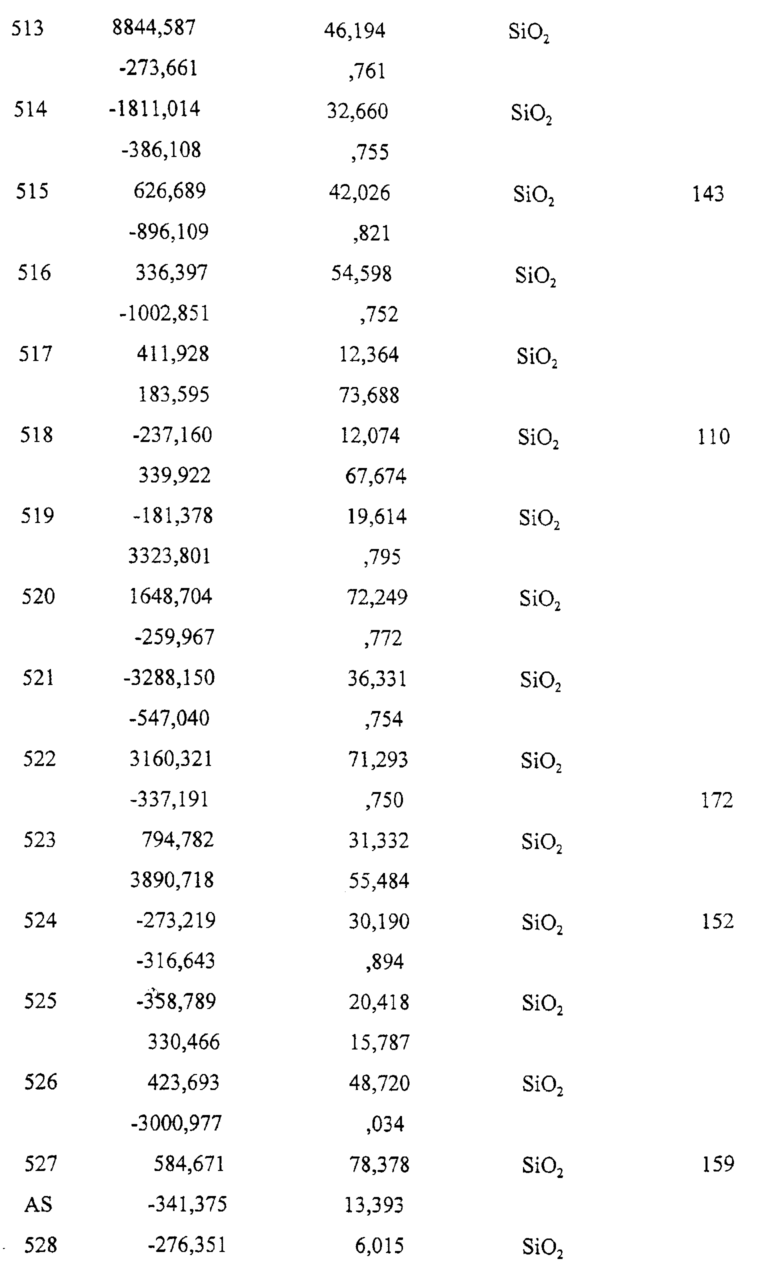

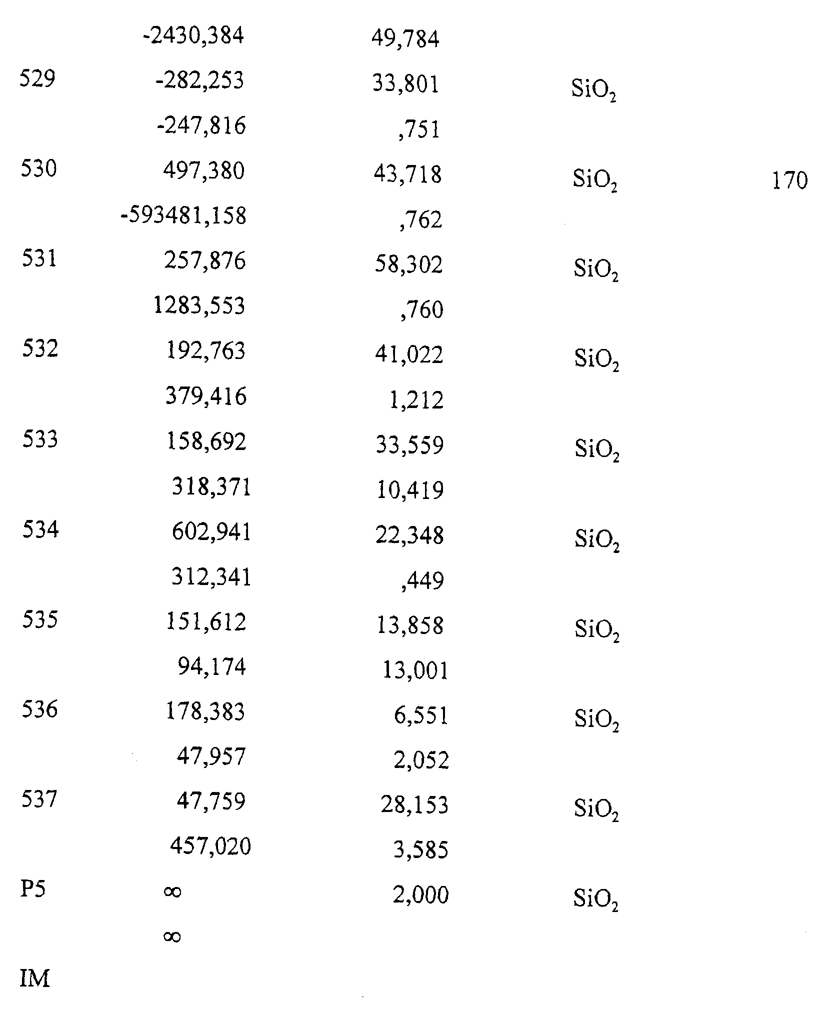

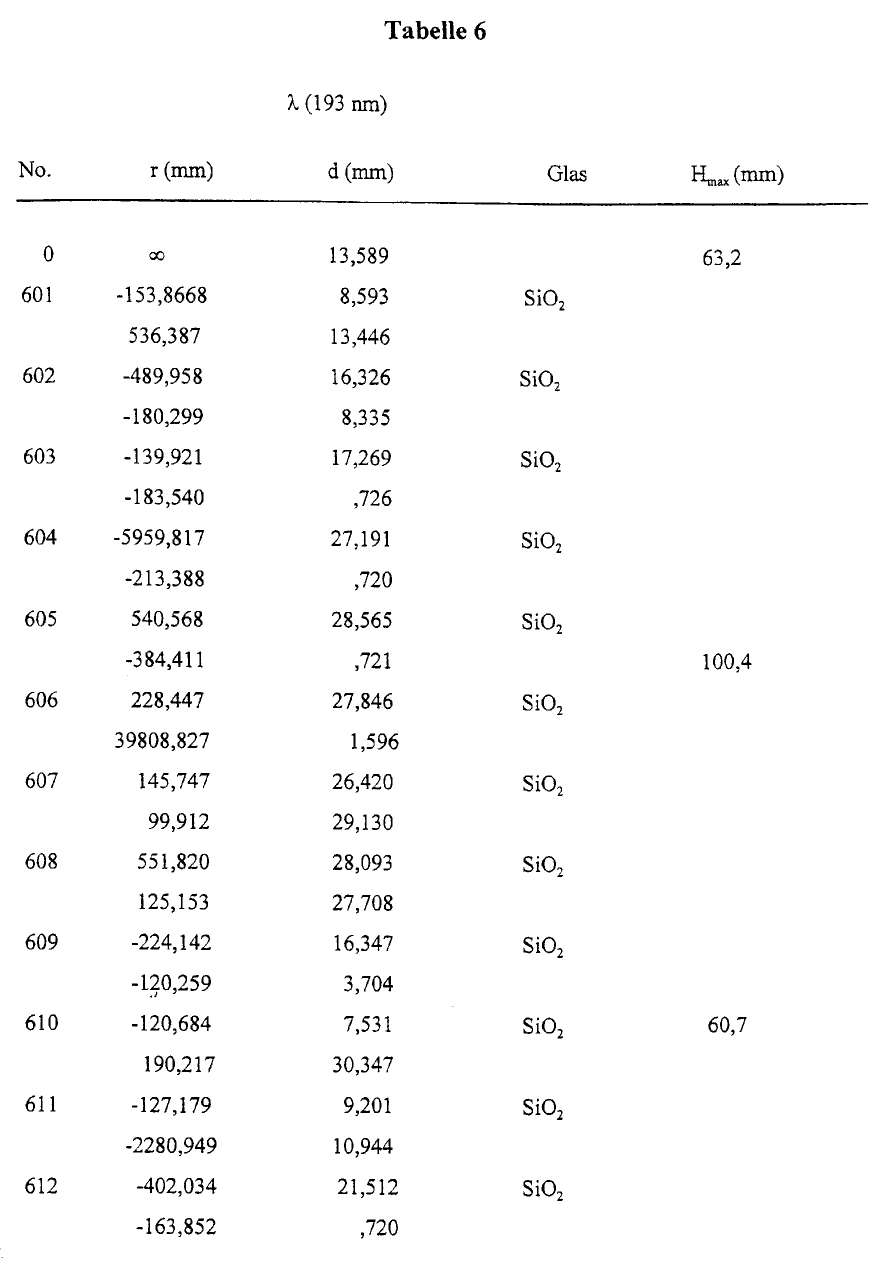

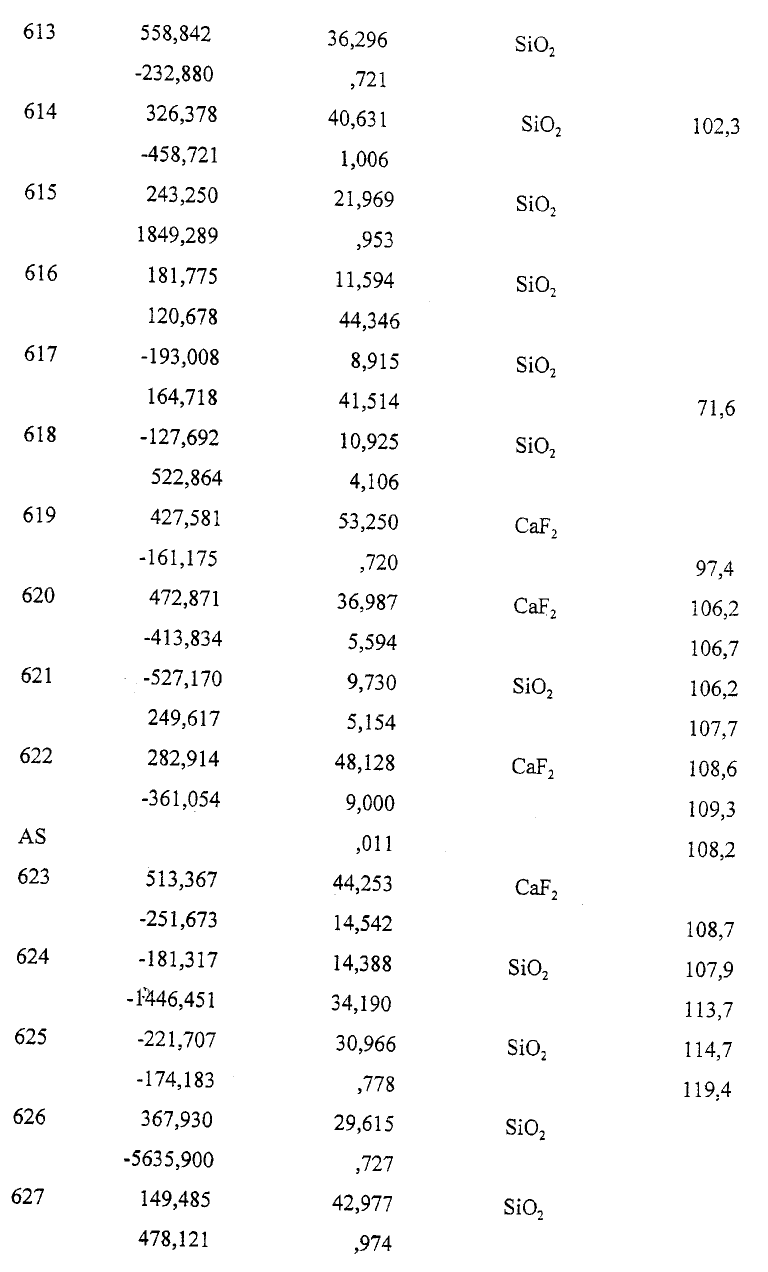

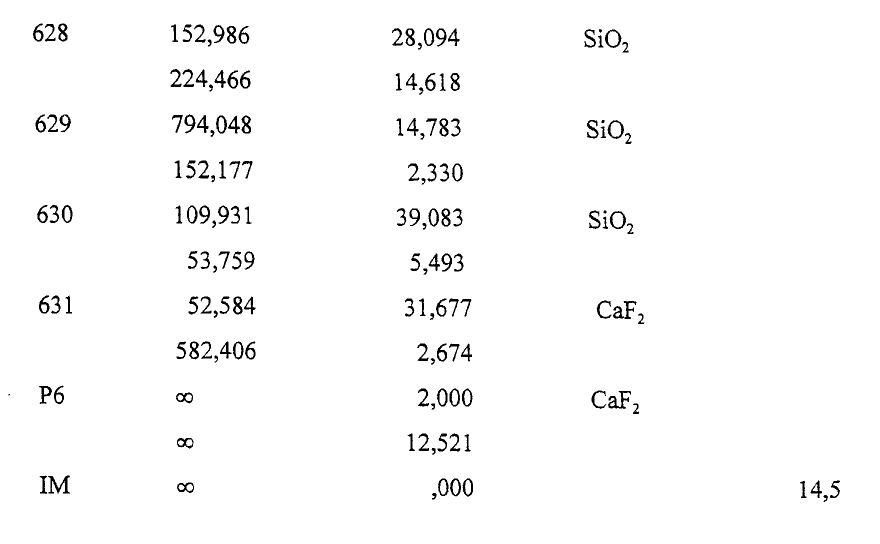

## Patentansprüche

1. Projektionsobjektiv mit mindestens drei Taillen des Lichtbündels.

2. Projektionsobjektiv mit einer Linsenanordnung, bestehend aus
- einer ersten positiven Linsengruppe (LG1)
- einer ersten negativen Linsengruppe (LG2)
- einer zweiten positiven Linsengruppe (LG3)
- einer zweiten negativen Linsengruppe (LG4)
- einer weiteren Linsenanordnung (LG5 bis LG7) enthaltend die Aperturblende (AS),
wobei jeweils mindestens eine (L21, L24) der zwei nächsten Linsen (L21, L22; L23, L24) vor und/oder nach der Aperturblende (AS) negative Brechkraft hat.

3. Projektionsobjektiv mit einer Linsenanordnung, bestehend aus
einer ersten positiven Linsengruppe (LG1)
einer ersten negativen Linsengruppe (LG2)
einer zweiten positiven Linsengruppe (LG3)
einer zweiten negativen Linsengruppe(LG4)
einer weiteren Linsenanordnung (LG5 bis LG7) enthaltend die Aperturblende (AS) und mindestens drei Linsen (L18 bis L22) vor der Aperturblende (AS).

4. Projektionsobjektiv mit einer Linsenanordnung , bestehend aus
einer ersten positiven Linsengruppe (LG1)
einer ersten negativen Linsengruppe(LG2)
einer zweiten positiven Linsengruppe (LG3)
einer zweiten negativen Linsengruppe (LG4)
und einer weiteren Linsenanordnung (LG5 bis LG7) enthaltend die Aperturblende (AS)
und vor dieser mindestens einen sphärisch überkorrigierenden Luftraum zwischen benachbarten Linsen (L20, L21).
■

5. Projektionsobjektiv mit mindestens zwei Taillen und drei Bäuchen,
dadurch gekennzeichnet, daß die Systemblende (AS) im Bereich des bildseitig letzten Bauches angeordnet ist und von den jeweils zwei Linsen (L21, L22; L23, L24) vor und/oder nach der Systemblende (AS) mindestens eine Linse (L21, L24) negativ ist.

6. Projektionsobjektiv nach mindestens zwei der Ansprüche 1 bis 5.

7. Projektionsobjektiv nach mindestens einem der Ansprüche 1 bis 6, dadurch gekennzeichnet, daß es eine bildseitige numerische Apertur von mindestens 0,65, vorzugsweise größer gleich 0,70 aufweist.

8. Projektionsobjektiv nach mindestens einem der Ansprüche 1 bis 7, dadurch gekennzeichnet, daß alle Linsen aus dem gleichen Material bestehen.

9. Projektionsobjektiv nach Anspruch 8, dadurch gekennzeichnet, daß es als reines Quarzglas-Objektiv aufgebaut ist.

10. Projektionsobjektiv nach mindestens einem der Ansprüche 1 bis 7, dadurch gekennzeichnet, daß die Linsen aus zwei verschiedenen Materialien bestehen.

11. Projektionsobjektiv nach mindestens einem der Ansprüche 1 bis 7 und/oder 10, dadurch gekennzeichnet, daß es als teilachromatisiertes Quarzglas/Kalziumfluorid-Objektiv, insbesondere für 193 nm Wellenlänge, aufgebaut ist.

12. Projektionsobjektiv nach mindestens einem der Ansprüche 1 bis 11, dadurch gekennzeichnet, daß vor und nach der Aperturblende (AS) jeweils mindestens eine (L21, L24) der zwei nächsten Linsen (L21, L22; L23, L24) negative Brechkraft hat.

13. Projektionsobjektiv nach mindestens einem der Ansprüche 2 und 5 bis 12, dadurch gekennzeichnet, daß angrenzend an die mindestens eine der zwei nächsten Linsen vor und/oder nach der Aperturblende mit negativer Brechkraft ein sphärisch überkorrigierender Luftraum angeordnet ist.

14. Projektionsobjektiv nach mindestens einem der Ansprüche 1 bis 13, dadurch gekennzeichnet, daß von den objektseitig ersten drei Linsen zwei negative Brechkraft aufweisen, vorzugsweise in -+- oder --+ Anordnung.

15. Projektionsbelichtungsanlage der Mikrolithographie, dadurch gekennzeichnet, daß sie ein Projektionsobjektiv nach mindestens einem der Ansprüche 1 bis 14 enthält.

16. Verfahren zur Herstellung mikrostrukturierter Bauteile, bei dem ein mit einer lichtempfindlichen Schicht versehenes Substrat mittels einer Maske und einer Projektionsbelichtungsanlage nach Anspruch 13 belichtet wird und insbesondere nach Entwickeln der lichtempfindlichen Schicht entsprechend einem aufder Maske enthaltenen Muster strukturiert wird.
